# EUROPEAN PATENT APPLICATION

(11) **EP 3 142 249 A1**
(43) Date of publication of application: **15.03.2017**
(21) Application number: 15184977.5
(22) Date of filing: 14.09.2015
(51) Int. Cl.: H03F 1/26, H03F 3/193, H03F 3/45, H03F 3/26

(54) **METHOD AND APPARATUS FOR AMPLIFYING SIGNALS**

(71) Applicant: Nokia Technologies Oy, 02610 Espoo (FI)
(72) Inventor: Östman, Kim, 00530 Helsinki (FI)
(74) Representative: Nokia Corporation

(57) **Abstract**

There are disclosed various methods and apparatuses for amplifying a signal. In some embodiments of the method a signal is provided to an input (S) of a transconducting element (T) of an amplifier. An amplified signal is formed on the basis of the input signal by the transconducting element (T). The amplified signal is provided to an output stage. A negative conductance (R_{neg}) in the output stage is used to adjust a gain and a noise figure of the amplifier. The amplified signal is provided via a feedback element (ßC_{fb}) to another input (G) of the transconducting element (T). In some embodiments the apparatus comprises means for implementing the method.

## Description

### TECHNICAL FIELD

The present invention relates to a method for amplifying signals and an apparatus for amplifying signals.

### BACKGROUND

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

In some apparatuses a low-noise amplifier (LNA) may be used to amplify signals so that noise possibly contributed by the amplifier is as weak as possible. These kinds of amplifiers may be used, for example, in radio receivers in a so called radio frequency (RF) front end. The low noise amplifier is intended to amplify possibly quite weak signals received by an antenna before the received signals are coupled to a mixer for converting the radio frequency signals to intermediate frequency (IF) signals or to baseband (BB) signals.

A common-gate (CG) topology is a popular low noise amplifier (LNA) choice in wireless receivers. This is in part thanks to the ease of input matching, which may be taken care of by proper sizing of the amplifying transistor. For example, a transconductance may be selected to gₘ = 20 mS in a system in which an input impedance to the low-noise amplifier is Rₛ = 50 Ω. A large external matching circuit may not be required as in many common-source topologies. However, this ease of matching may constrain the achievable LNA noise figure (NF) and voltage gain (Aᵥ), for example such that NFₘᵢₙ = 2.2 dB. When accounting for the load impedance, the real NF may be considerably higher. For example, for a high-impedance load of R_{L} = 300 Ω, the noise figure may be about 3.66 dB. The gain in turn may be limited by a fixed gₘ and the limited load impedance magnitude that may be implemented without serious drawbacks. Limited LNA gain then may further raise the receiver NF. The lack of LNA tuning possibilities due to a required fixed gₘ may be another drawback. Furthermore, coupling of strong blocker signals as voltages over a relatively flat input impedance may place linearity stress on an amplifying transistor.

### SUMMARY

Various embodiments provide a method and apparatus for amplifying signals and an apparatus for amplifying signals.

Various aspects of examples of the invention are provided in the detailed description.

According to a first aspect, there is provided a method comprising:
providing a signal to an input of a transconducting element of an amplifier;
forming an amplified signal on the basis of the input signal by the transconducting element;
providing the amplified signal to an output stage;
using a negative conductance in the output stage to adjust a gain and a noise figure of the amplifier; and
providing the amplified signal via a feedback element to another input of the transconducting element.

According to a second aspect, there is provided an apparatus comprising:
an input for inputting a signal to an amplifier;
a transconducting element for amplifying the inputted signal, wherein the transconducting element is adapted for forming an amplified signal on the basis of the input signal;
an output stage coupled with the transconducting element to receive the amplified signal;
a negative conductance in the output stage to adjust a gain and a noise figure of the amplifier;and
a feedback element for providing the amplified signal to another input of the transconducting element.

According to a third aspect, there is provided an apparatus comprising:
means for providing a signal to an input of a transconducting element of an amplifier;
means for forming an amplified signal on the basis of the input signal by the transconducting element;
means for providing the amplified signal to an output stage;
means for using a negative conductance in the output stage to adjust a gain and a noise figure of the amplifier; and
means for providing the amplified signal via a feedback element to another input of the transconducting element.

### BRIEF DESCRIPTION OF THE DRAWINGS

For a more complete understanding of example embodiments of the present invention, reference is now made to the following descriptions taken in connection with the accompanying drawings in which:
Figure 1 shows a simplified block diagram of a device according to an example embodiment;
Figure 2a illustrates as a simplified circuit diagram a generic schematic of the structure of an amplifier having single-ended input and output, in accordance with an embodiment;
Figure 2b illustrates as a simplified circuit diagram a generic schematic of the structure of an amplifier having differential input and output, in accordance with an embodiment;
Figure 2c illustrates as a simplified diagram an example of the structure of another amplifier having a single-ended input and differential output, in accordance with an embodiment;
Figure 2d illustrates as a simplified diagram an example of the structure of yet another amplifier having a single-ended input and differential output, in accordance with an embodiment;
Figure 3a illustrates as a graph representation simulation results of noise figure as a function of a negative load conductance, in accordance with an embodiment;
Figure 3b illustrates as a graph representation simulation results of a transconductance of a transistor of an amplifier for input match as a function of a negative load conductance, in accordance with another embodiment;
Figures 4a to 4f illustrate the effect of the negative conductance on the amplifier input impedance and gain, while keeping a feedback factor constant, in accordance with an embodiment;
Figures 5a and 5b illustrate the noise figure contribution of the negative conductance circuit, the possibly parasitic load impedance, and the common-gate amplifying transistor, in accordance with an embodiment;
Figures 6a to 6f show how increasing the feedback factor may affect the performance of the amplifier, for a fixed non-zero negative resistance, in accordance with an embodiment;
Figure 7 shows a block diagram of an apparatus according to an example embodiment;
Figure 8 shows an apparatus according to an example embodiment;
Figure 9 shows an example of an arrangement for wireless communication comprising a plurality of apparatuses, networks and network elements.

### DETAILED DESCRIPTON OF SOME EXAMPLE EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

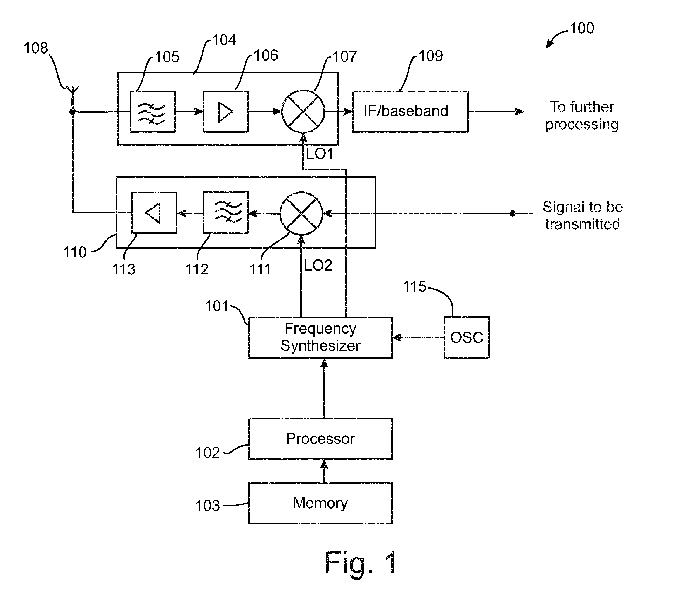

Figure 1 depicts an example of a part of a device 100, which may be, for example, a mobile device such as a mobile phone, but may also be another device comprising an amplifier 106. The device 100 may be constructed to include the frequency synthesizer 101 for generating one or more oscillator signals. The device may comprise one or more data processors 102 for controlling the operations of the device, in accordance with an embodiment. The data processor 102 operates in accordance with program instructions stored in at least one storage medium, such as at least one memory 103. The data processor 102 may control the frequency synthesizer 101 for setting the output frequency/frequencies of the frequency synthesizer 101. These output frequencies form one or more local oscillator signals that may be applied simultaneously to an RF receiver circuitry 104. The RF receiver circuitry 104 may include one or multiple instances of filters 105, amplifiers 106 and mixers 107. The RF receiver circuitry 104 may be configured to be coupled with at least one, and possibly several antennas 108, and may operate to simultaneously receive and down-convert multiple reception channels in multiple frequency bands. The RF receiver circuitry 104 may be implemented e.g. as a single direct conversion receiver, as a plurality of direct conversion receivers, as a single superheterodyne-type receiver or as a plurality of superheterodyne-type receivers. In either case the down-converted signals from multiple reception channels are provided to at least one baseband circuitry block 109 to demodulate and decode received signaling and other data.

The device of Figure 1 also comprises an RF transmitter 110 for transmitting radio frequency signals. The transmitter 110 may comprise one or more mixers 111 adapted to receive signals to be transmitted and a local oscillator signal LO2. The mixing result may be provided to a band pass filter 112 to filter out mixing results which are out of the transmission band, and a power amplifier 113 to amplify the RF signals before passing them to one or more antennas 108. The one or more antennas 108 may be the same one or more antennas that the RF receiver circuitry 104 uses or different antenna(s).

The RF receiver circuitry 104, the RF transmitter 110 and/or the baseband circuitry 109 may be embodied as an integrated circuit. In some embodiments the RF receiver circuitry 104, the RF transmitter 110 and the baseband circuitry 109 or parts of them may be embodied in the same integrated circuit, and in some other embodiments they may be embodied in different integrated circuits. In some embodiments all of the circuitry shown in Figure 1, including the data processor 102 and possibly also the memory 103, may be embodied in one integrated circuit module or package.

In some embodiments all or some of the functionality of the frequency synthesizer 101 may be embodied by the data processor 102 or by another data processor, such as a high speed digital signal processor operating under control of a stored program.

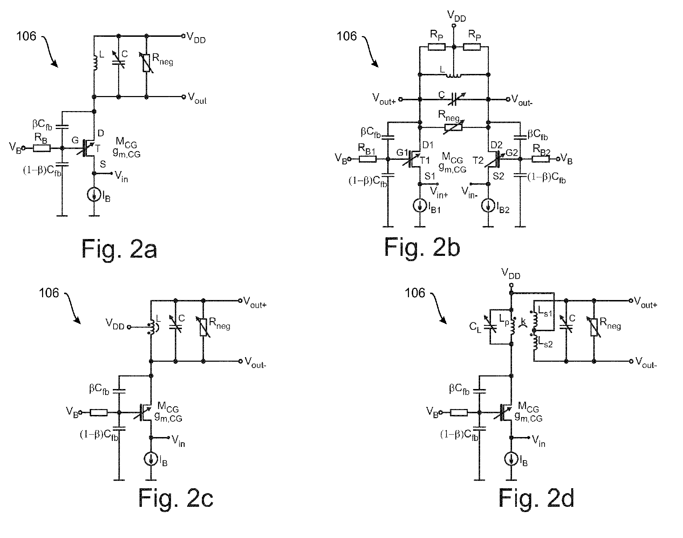

Figure 2a depicts as a simplified circuit diagram a principle of the amplifier 106, in accordance with an embodiment. The amplifier 106 may be, for example, a low noise amplifier (LNA). The amplifier 106 of Figure 2a may be based on a common-gate stage (M_{CG}). The amplifier 106 may have tunable noise figure (NF), tunable gain, and/or tunable out-of-band input impedance.

In the embodiment of Figure 2a the amplifier 106 has a single-ended input Vᵢₙ and a single-ended output Vₒᵤₜ. In this embodiment, the input Vᵢₙ is coupled to a source S of a common-gate stage T. A bias current source I_{B} is coupled between the source S of the common-gate stage T and ground. A bias voltage V_{B} is provided to a gate of the common-gate stage T. The bias voltage V_{B} for the common-gate stage may be provided through a bias resistor R_{B}.

The amplifier 106 also comprises an output stage (output tank) coupled between a drain D of the transconductive element T and a supply VDD. In this embodiment the output stage comprises a tunable LC resonance circuitry and a tunable negative conductance R_{neg}. The tunable resonance circuitry is implemented using a variable capacitance C, an inductance L and a real or parasitic resistance connected in parallel. A supply voltage V_{DD} is provided to the amplifier 106 via the tunable LC resonance circuit. The tunable negative conductance is formed using a tunable negative resistance R_{neg}, which is coupled in parallel with the tunable resonance circuitry.

The amplifier 106 further comprises a series-shunt feedback circuitry for the common-gate stage T. In this embodiment, the series-shunt feedback comprises a first feedback capacitance between the drain D and the gate G of the transconductive element T and a second feedback capacitance coupled between the gate G of the transconductive element T and ground. Values for the feedback capacitances may be selected so that the first feedback capacitance has a value βC_{fb} and the second feedback capacitance has a value (1-β)C_{fb}. Hence, the feedback factor is β (=βC_{fb}/((1-β)C_{fb}+βC_{fb})). The feedback factor β may be selected and/or tuned on the basis of system requirements. In other words, the effect of the feedback may be changed to account for varying operating conditions by tuning the feedback factor β. In practice this may be done, for example, by changing the relative values of the feedback path capacitors (1-β)C_{fb}, βC_{fb}. To keep the input matched, the transconductance g_{m,CG} may also be tuned.

In operation, the resonance of the output stage may be tuned to correspond with the frequency range of the signal to be received, wherein the amplifier 106 may be able to amplify signals which are located within the selected frequency range and to attenuate signals outside this frequency range.

The tunable negative resistance R_{neg} circuit may lower the noise figure of the amplifier 106. The tunable negative resistance R_{neg} circuit may further allow tunability, when combined with the tunable capacitive voltage feedback and tunable transconductance g_{m,CG} of the common-gate stage M_{CG}.

The tunable negative resistance R_{neg} circuit may also provide higher amplifier gain and thus lower receiver noise figure compared to amplifiers without the tunable negative resistance R_{neg} circuit. The out-of-band input impedance of the amplifier may be lowered with the effects caused by the tunable negative resistance R_{neg}, thus reducing out-of-band linearity stress from the input transconductor, because blocker voltage build-up may be reduced at the input vᵢₙ. In other words, there is provided an amplifier 106 whose gain, noise, and linearity performance may be adapted according to operating conditions.

In the embodiment of Figure 2b the amplifier 106 has a differential input (Vᵢₙ₊, Vᵢₙ₋) and a differential output (Vₒᵤₜ₊, Vₒᵤₜ₋). In this embodiment, one terminal Vᵢₙ₊ of the differential input is coupled to a source S1 of a first common-gate stage T1 of the two common-gate stages and the other terminal Vᵢₙ₋ of the differential input is coupled to a source S2 of a second common-gate stage T2 of the two common-gate stages. A first bias current source I_{B1} is coupled between the source S1 of the first common-gate stage T1 and ground, and a second bias current source I_{B2} is coupled between the source S2 of the second common-gate stage T1 and ground. A bias voltage V_{B} is provided to a gate of the first common-gate stage T1 and to a gate of the second common-gate stage T2. The bias voltage V_{B} for the two common-gate stages may be provided through bias resistors R_{B1}, R_{B2}.

The amplifier 106 also comprises an output stage (output tank) coupled between a drain D1 of the first transconductive element T1 and a drain D2 of the second transconductive element T2. In this embodiment the output stage comprises a tunable LC resonance circuitry and a tunable negative conductance R_{neg}. The tunable resonance circuitry is implemented using a variable capacitance C, an inductance L and a real or parasitic resistance connected in parallel. The inductance L has a centre tap for receiving a supply voltage V_{DD}. The resistance is formed of two resistors R_{P} so that one of the resistors is in parallel with a first half of the inductance L and the other resistor is in parallel with a second half of the inductance L. Hence, the mutual terminal of the resistors R_{P} is also coupled to the supply voltage. The tunable negative conductance is formed using a tunable negative resistance R_{neg}, which is coupled in parallel with the tunable resonance circuitry.

The amplifier 106 further comprises a series-shunt feedback circuitry for both common-gate stages T1, T2. In this embodiment, the series-shunt feedback comprises a first feedback capacitance between the drain D1, D2 and the gate G1, G2 of the transconductive element T1, T2 and a second feedback capacitance coupled between the gate G1, G2 of the transconductive element T1, T2 and ground. Values for the feedback capacitances may be selected so that the first feedback capacitance has a value βC_{fb} and the second feedback capacitance has a value (1-β)C_{fb}. Hence, the feedback factor is β (=βC_{fb}/((1-β)C_{fb}+βC_{fb})). The feedback factor β may be selected and/or tuned on the basis of system requirements. In other words, the effect of the feedback may be changed to account for varying operating conditions by tuning the feedback factor β. In practice this may be done, for example, by changing the relative values of the feedback path capacitors (1-β)C_{fb}, βC_{fb}. To keep the input matched, the transconductane g_{m,CG} may also be tuned.

In the following, some examples of tunable amplifiers 106 having a single-ended input and differential output are discussed in more detail. Using a single-ended input may enable to use fewer high-frequency input/output pins of an integrated circuit than in differential input designs, whereas a differential output may increase the available signal swing and the robustness against common-mode noise sources at stages following the amplifier 106.

To enable this property, the amplifier 106 may be modified as shown in Figures 2c and 2d. In the example of Figure 2c, the single-ended to differential conversion may be achieved by using at the output stage a amplifier load inductor L that provides natural magnetic coupling. The amplifier load inductor L may be, for example, a symmetric center-tapped inductor. The output stage also comprises the tunable capacitance C and the tunable negative resistance R_{neg} connected in parallel with the inductor L.

The solution presented in Figure 2d provides the conversion by using a transformer at the amplifier output stage instead. The transformer has a primary winding Lₚ, which is connected in series between the drain of the transconductive element M_{CG} and the supply voltage V_{DD}, and two secondary windings Lₛ₁, Lₛ₂. A mutual terminal of the secondary windings Lₛ₁, Lₛ₂ is coupled to the supply voltage V_{DD}. The output stage further comprises the tunable capacitance C and the tunable negative resistance R_{neg} connected in parallel with the secondary windings Lₛ₁, Lₛ₂.

The first transconductance element and the second transconductance element may be, for example, field effect transistors (FET), such as metal-oxide silicon FETs (MOSFET), or other appropriate kinds of transistors, such as bipolar transistors.

In accordance with an embodiment, the feedback may affect the input matching condition of the common-gate stage M_{CG} such that it becomes g_{m,CG} = 30 mS for a 50-Ω system instead of g_{m,CG} = 20 mS for a 50-Ω system.

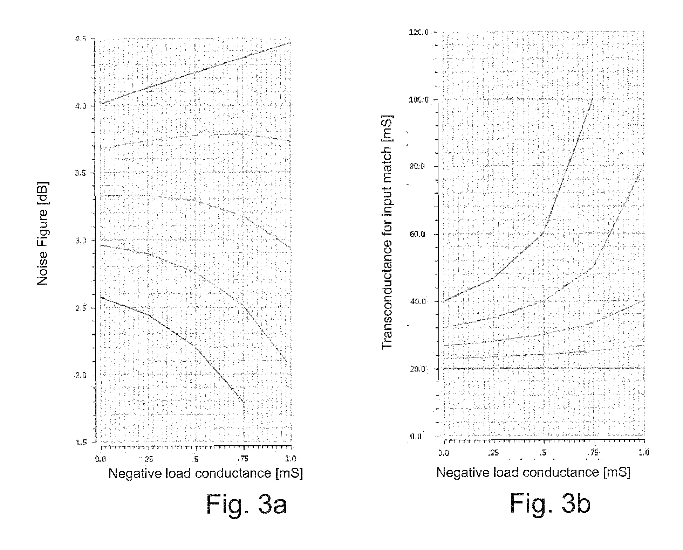

Figure 3a illustrates as a graph representation some simulation results of noise figure as a function of a negative load conductance, in accordance with an embodiment. In this example the performance of the differential version of the amplifier is simulated using an LC load that is tuned to 2 GHz and whose finite Q is modeled by a parasitic Rₚ = 250 Ω. Each curve corresponds to a value of the feedback factor β in the range 0-0.1. By designing β > 0 properly, increased negative conductance may reduce the noise figure of the amplifier 106, even to below 2 dB. As shown in Figure 3b, a simultaneous increase in transconductance g_{m,CG} may keep the amplifier input matched. In Figure 3b the curves correspond the simulated feedback factors β from top to down as follows: the top-most curve is a simulation result when the feedback factor β was 0.1, the next curve is a simulation result when the feedback factor β was 0.075, the curve in the middle is a simulation result when the feedback factor β was 0.05, the second lowest curve is a simulation result when the feedback factor β was 0.025, and the lowest curve is a simulation result when the feedback factor β was 0.

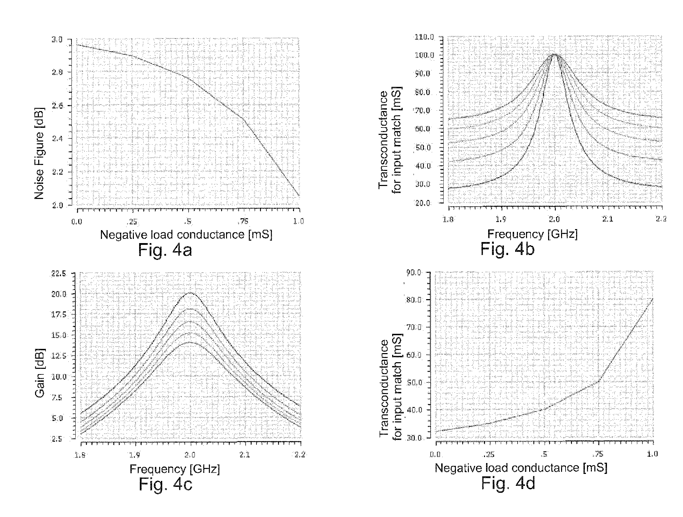

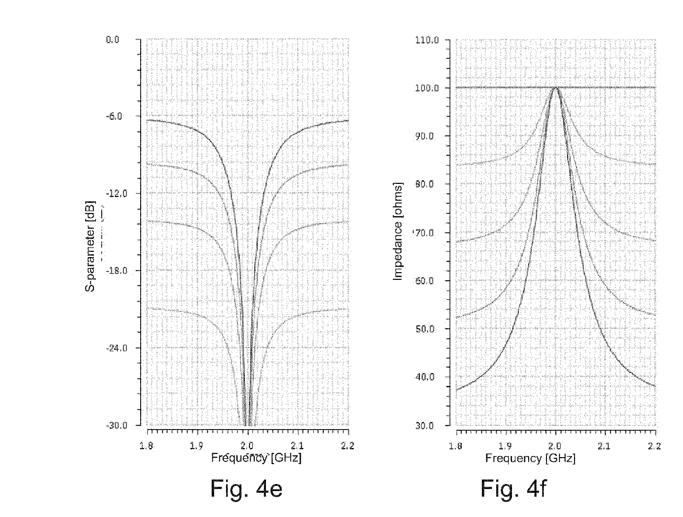

Figures 4a to 4f illustrate the effect of the negative conductance on the amplifier input impedance and gain, while keeping a feedback factor constant, in accordance with an embodiment. In this example, the feedback factor β is 0.075 and Rₚ = 250 Ω. Figure 4a illustrates the noise figure as a function of the negative conductance value. Figure 4b illustrates the input impedance matching in ohms as a function of the frequency. In Figure 4b the curves correspond the simulated negative conductance values from top to down as follows: the top-most curve is a simulation result when the negative conductance value was 0.0 S, the next curve is a simulation result when the negative conductance value was 0.00025 S, the curve in the middle is a simulation result when the negative conductance value was 0.0005 S, the second lowest curve is a simulation result when the negative conductance value was 0.00075 S, and the lowest curve is a simulation result when the negative conductance value was 0.001 S. Figure 4c illustrates the gain in dB as a function of the frequency. In Figure 4c the curves correspond the simulated negative conductance values from top to down as follows: the top-most curve is a simulation result when the negative conductance value was 0.001 S, the next curve is a simulation result when the negative conductance value was 0.00075 S, the curve in the middle is a simulation result when the negative conductance value was 0.0005 S, the second lowest curve is a simulation result when the negative conductance value was 0.00025 S, and the lowest curve is a simulation result when the negative conductance value was 0.001 S. Figure 4d illustrates the transconductance of the common-gate stage as a function of the negative conductance value. Figure 4e illustrates an S-parameter S₁₁ as a function of the frequency with different negative conductance values. In Figure 4e the curves correspond the simulated negative conductance values from top to down as follows: the top-most curve is a simulation result when the negative conductance value was 0.001 S, the next curve is a simulation result when the negative conductance value was 0.00075 S, the curve in the middle is a simulation result when the negative conductance value was 0.0005 S, the second lowest curve is a simulation result when the negative conductance value was 0.00025 S, and the lowest curve is a simulation result when the negative conductance value was 0.001 S.Figure 4f illustrates the input impedance Zᵢₙ of the common-gate stage as a function of the frequency with different negative conductance values. In Figure 4f the curves correspond the simulated negative conductance values from top to down as follows: the top-most curve is a simulation result when the negative conductance value was 0.0 S, the next curve is a simulation result when the negative conductance value was 0.00025 S, the curve in the middle is a simulation result when the negative conductance value was 0.0005 S, the second lowest curve is a simulation result when the negative conductance value was 0.00075 S, and the lowest curve is a simulation result when the negative conductance value was 0.001 S.

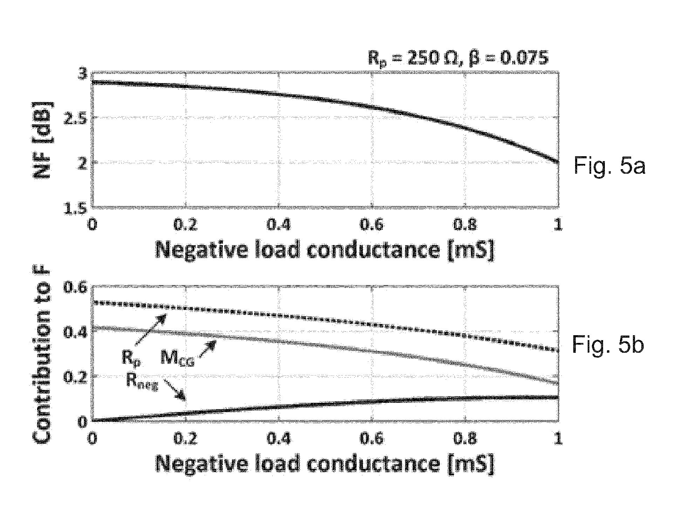

Figures 5a and 5b show the noise figure contribution of the negative conductance circuit R_{neg} (assumed to be a cross-coupled NMOS pair), the parasitic load impedance Rₚ, and the common gate stage, in accordance with an embodiment. The negative conductance R_{neg} may add noise. The reduced noise figure may be based on increasingly stronger internal amplifier feedback through the feedback capacitance C_{fb}, which may attenuate the contributions by Rₚ and M_{CG}.

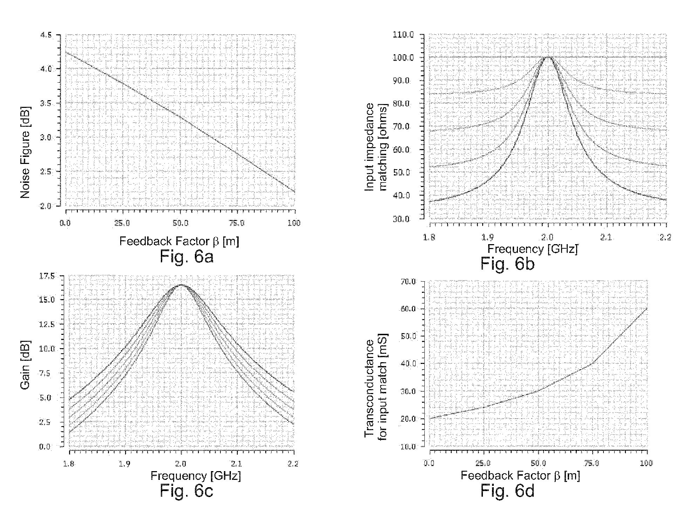

Figures 6a to 6f show how increasing the feedback factor may affect the performance of the amplifier, for a fixed non-zero negative resistance R_{neg}, in accordance with an embodiment. It can be seen that an increase in the feedback factor β may reduce the quality of the out-of-band input matching (*S₁₁*), and that the deterioration may happen specifically due to a decrease in the out-of-band input impedance. In Figure 6b the curves correspond the simulated feedback factors β from top to down as follows: the top-most curve is a simulation result when the feedback factor β was 0.0, the next curve is a simulation result when the feedback factor β was 0.025, the curve in the middle is a simulation result when the feedback factor β was 0.05, the second lowest curve is a simulation result when the feedback factor β was 0.075, and the lowest curve is a simulation result when the feedback factor β was 0.1. In Figure 6c the curves correspond the simulated feedback factors β from top to down as follows: the top-most curve is a simulation result when the feedback factor β was 0.1, the next curve is a simulation result when the feedback factor β was 0.075, the curve in the middle is a simulation result when the feedback factor β was 0.05, the second lowest curve is a simulation result when the feedback factor β was 0.025, and the lowest curve is a simulation result when the feedback factor β was 0.0.

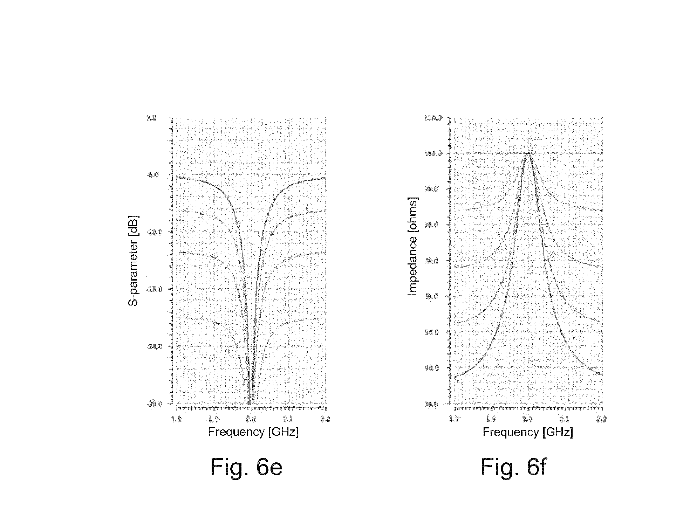

In Figure 6e the curves correspond the simulated feedback factors β from top to down as follows: the top-most curve is a simulation result when the feedback factor β was 0.1, the next curve is a simulation result when the feedback factor β was 0.075, the second lowest curve in the middle is a simulation result when the feedback factor β was 0.05, and the lowest curve is a simulation result when the feedback factor β was 0.1. In Figure 6f the curves correspond the simulated feedback factors β from top to down as follows: the top-most curve is a simulation result when the feedback factor β was 0.0, the next curve is a simulation result when the feedback factor β was 0.025, the curve in the middle is a simulation result when the feedback factor β was 0.05, the second lowest curve is a simulation result when the feedback factor β was 0.075, and the lowest curve is a simulation result when the feedback factor β was 0.1.

The amplifier structure presented above may provide greater design freedom and performance versatility than amplifier structures which do not utilize the tunable feedback and/or the tunable negative conductance. The common-gate amplifier 106 may be used to obtain a lower noise figure than common-gate amplifiers without such tunability, even down to below 2 dB. The negative conductance circuit may also reduce the receiver noise figure thanks to higher amplifier gain, while at the same time providing lower out-of-band input impedance and thus greater tolerance against blockers at the input transconductor. The presented circuitry may further provide the possibility of tuning the amplifier gain, the noise figure, and the out-of-band input impedance depending on varying operating conditions. The single-ended-input embodiment may also save at least one high-frequency input/output pin in multi-band receivers with parallel low-noise amplifiers.

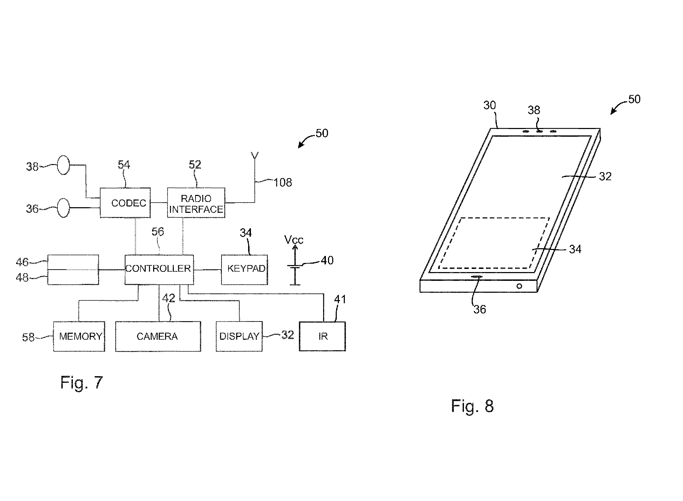

The following describes in further detail suitable apparatus and possible mechanisms for implementing the embodiments of the invention. In this regard reference is first made to Figure 7 which shows a schematic block diagram of an exemplary apparatus or electronic device 50 depicted in Figure 8, which may incorporate a transmitter according to an embodiment of the invention.

The electronic device 50 may for example be a mobile terminal or user equipment of a wireless communication system. However, it would be appreciated that embodiments of the invention may be implemented within any electronic device or apparatus which may require transmission of radio frequency signals.

The apparatus 50 may comprise a housing 30 for incorporating and protecting the device. The apparatus 50 further may comprise a display 32 in the form of a liquid crystal display. In other embodiments of the invention the display may be any suitable display technology suitable to display an image or video. The apparatus 50 may further comprise a keypad 34. In other embodiments of the invention any suitable data or user interface mechanism may be employed. For example the user interface may be implemented as a virtual keyboard or data entry system as part of a touch-sensitive display. The apparatus may comprise a microphone 36 or any suitable audio input which may be a digital or analogue signal input. The apparatus 50 may further comprise an audio output device which in embodiments of the invention may be any one of: an earpiece 38, speaker, or an analogue audio or digital audio output connection. The apparatus 50 may also comprise a battery 40 (or in other embodiments of the invention the device may be powered by any suitable mobile energy device such as solar cell, fuel cell or clockwork generator). The term battery discussed in connection with the embodiments may also be one of these mobile energy devices. Further, the apparatus 50 may comprise a combination of different kinds of energy devices, for example a rechargeable battery and a solar cell. The apparatus may further comprise an infrared port 41 for short range line of sight communication to other devices. In other embodiments the apparatus 50 may further comprise any suitable short range communication solution such as for example a Bluetooth wireless connection or a USB/firewire wired connection.

The apparatus 50 may comprise a controller 56 or processor for controlling the apparatus 50. The controller 56 may be connected to memory 58 which in embodiments of the invention may store both data and/or may also store instructions for implementation on the controller 56. The controller 56 may further be connected to codec circuitry 54 suitable for carrying out coding and decoding of audio and/or video data or assisting in coding and decoding carried out by the controller 56.

The apparatus 50 may further comprise a card reader 48 and a smart card 46, for example a universal integrated circuit card (UICC) reader and a universal integrated circuit card for providing user information and being suitable for providing authentication information for authentication and authorization of the user at a network.

The apparatus 50 may comprise radio interface circuitry 52 connected to the controller and suitable for generating wireless communication signals for example for communication with a cellular communications network, a wireless communications system or a wireless local area network. The apparatus 50 may further comprise an antenna 108 connected to the radio interface circuitry 52 for transmitting radio frequency signals generated at the radio interface circuitry 52 to other apparatus(es) and for receiving radio frequency signals from other apparatus(es).

In some embodiments of the invention, the apparatus 50 comprises a camera 42 capable of recording or detecting imaging.

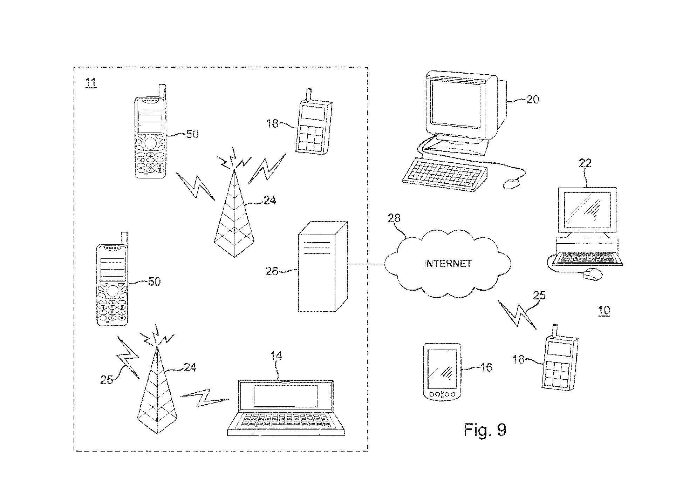

With respect to Figure 9, an example of a system within which embodiments of the present invention can be utilized is shown. The system 10 comprises multiple communication devices which can communicate through one or more networks. The system 10 may comprise any combination of wired and/or wireless networks including, but not limited to a wireless cellular telephone network (such as a global systems for mobile communications (GSM), universal mobile telecommunications system (UMTS), long term evolution (LTE) based network, code division multiple access (CDMA) network etc.), a wireless local area network (WLAN) such as defined by any of the IEEE 802.x standards, a Bluetooth personal area network, an Ethernet local area network, a token ring local area network, a wide area network, and the Internet.

For example, the system shown in Figure 9 shows a mobile telephone network 11 and a representation of the internet 28. Connectivity to the internet 28 may include, but is not limited to, long range wireless connections, short range wireless connections, and various wired connections including, but not limited to, telephone lines, cable lines, power lines, and similar communication pathways.

The example communication devices shown in the system 10 may include, but are not limited to, an electronic device or apparatus 50, a combination of a personal digital assistant (PDA) and a mobile telephone 14, a PDA 16, an integrated messaging device (IMD) 18, a desktop computer 20, a notebook computer 22, a tablet computer. The apparatus 50 may be stationary or mobile when carried by an individual who is moving. The apparatus 50 may also be located in a mode of transport including, but not limited to, a car, a truck, a taxi, a bus, a train, a boat, an airplane, a bicycle, a motorcycle or any similar suitable mode of transport.

Some or further apparatus may send and receive calls and messages and communicate with service providers through a wireless connection 25 to a base station 24. The base station 24 may be connected to a network server 26 that allows communication between the mobile telephone network 11 and the internet 28. The system may include additional communication devices and communication devices of various types.

The communication devices may communicate using various transmission technologies including, but not limited to, code division multiple access (CDMA), global systems for mobile communications (GSM), universal mobile telecommunications system (UMTS), time divisional multiple access (TDMA), frequency division multiple access (FDMA), transmission control protocol-internet protocol (TCP-IP), short messaging service (SMS), multimedia messaging service (MMS), email, instant messaging service (IMS), Bluetooth, IEEE 802.11, Long Term Evolution wireless communication technique (LTE) and any similar wireless communication technology. A communications device involved in implementing various embodiments of the present invention may communicate using various media including, but not limited to, radio, infrared, laser, cable connections, and any suitable connection. In the following some example implementations of apparatuses utilizing the present invention will be described in more detail.

Although the above examples describe embodiments of the invention operating within a wireless communication device, it would be appreciated that the invention as described above may be implemented as a part of any apparatus comprising a circuitry in which radio frequency signals are transmitted and received. Thus, for example, embodiments of the invention may be implemented in a mobile phone, in a base station, in a computer such as a desktop computer or a tablet computer comprising radio frequency communication means (e.g. wireless local area network, cellular radio, etc.).

In general, the various embodiments of the invention may be implemented in hardware or special purpose circuits or any combination thereof. While various aspects of the invention may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

In the following some examples will be provided.

According to a first example, there is provided a method comprising:
providing a signal to an input of a transconducting element of an amplifier;
forming an amplified signal on the basis of the input signal by the transconducting element;
providing the amplified signal to an output stage;
using a negative conductance in the output stage to adjust a gain and a noise figure of the amplifier; and
providing the amplified signal via a feedback element to another input of the transconducting element.

In some embodiments the method comprises:
generating the amplified signal as a differential output signal comprising a positive output signal and a negative output signal; and
using the negative output signal to form the feedback signal.

In some embodiments the method comprises:
using a single-ended input as said input of the transconducting element of the amplifier; and
using a transformer at the output stage to form the differential output signal.

In some embodiments the method comprises:
adjusting the negative conductance to increase the gain and to decrease the noise figure.

In some embodiments the method comprises:
using a capacitance as the feedback element.

In some embodiments the method comprises:
using a biasing input of the transconducting element as said another input.

According to a second example, there is provided an apparatus comprising:
an input for inputting a signal to an amplifier;
a transconducting element for amplifying the inputted signal, wherein the transconducting element is adapted for forming an amplified signal on the basis of the input signal;
an output stage coupled with the transconducting element to receive the amplified signal;
a negative conductance in the output stage to adjust a gain and a noise figure of the amplifier;and
a feedback element for providing the amplified signal to another input of the transconducting element.

In some embodiments the apparatus further comprises:
a differential output adapted to generate the amplified signal as a differential signal comprising a positive output signal and a negative output signal; and
wherein the feedback element is coupled to the negative output signal to form the feedback signal.

In some embodiments the apparatus further comprises:
a single-ended input coupled to said input of the transconducting element of the amplifier; and
a transformer at the differential output to form the differential output signal.

In some embodiments of the apparatus the negative conductance is an adjustable negative resistance.

In some embodiments of the apparatus the feedback element comprises a capacitor.

In some embodiments of the apparatus the output stage further comprises a tunable LC resonance circuit.

In some embodiments of the apparatus the transconducting element is a metal-oxide silicon field effect transistor.

In some embodiments of the apparatus the input is a differential input; wherein the apparatus comprises:
a first transconducting element and a second transconducting element for amplifying the differential input signal.

In some embodiments the apparatus is a part of a receiver of a wireless communication device.

According to a third example, there is provided an apparatus comprising:
means for providing a signal to an input of a transconducting element of an amplifier;
means for forming an amplified signal on the basis of the input signal by the transconducting element;
means for providing the amplified signal to an output stage;
means for using a negative conductance in the output stage to adjust a gain and a noise figure of the amplifier; and
means for providing the amplified signal via a feedback element to another input of the transconducting element.

In some embodiments the apparatus comprises:
means for generating the amplified signal as a differential output signal comprising a positive output signal and a negative output signal; and
means for using the negative output signal to form the feedback signal.

In some embodiments the apparatus comprises:
means for using a single-ended input as said input of the transconducting element of the amplifier; and
using a transformer at the output stage to form the differential output signal.

In some embodiments the apparatus comprises:
means for adjusting the negative conductance to increase the gain and to decrease the noise figure.

In some embodiments the apparatus comprises:
means for using a capacitance as the feedback element.

In some embodiments the apparatus comprises:
means for using a biasing input of the transconducting element as said another input.

## Claims

1. A method comprising:
providing a signal to an input of a transconducting element of an amplifier;
forming an amplified signal on the basis of the input signal by the transconducting element;
providing the amplified signal to an output stage;
using a negative conductance in the output stage to adjust a gain and a noise figure of the amplifier; and
providing the amplified signal via a feedback element to another input of the transconducting element.

2. The method according to claim 1 comprising:
generating the amplified signal as a differential output signal comprising a positive output signal and a negative output signal; and
using the negative output signal to form the feedback signal.

3. The method according to claim 2 comprising:
using a single-ended input as said input of the transconducting element of the amplifier; and
using a transformer at the output stage to form the differential output signal.

4. The method according to claim 1, 2 or 3 comprising:
adjusting the negative conductance to increase the gain and to decrease the noise figure.

5. The method according to any of the claims 1 to 4 comprising:
using a capacitance as the feedback element.

6. The method according to any of the claims 1 to 5 comprising:
using a biasing input of the transconducting element as said another input.

7. An apparatus comprising:
an input for inputting a signal to an amplifier;
a transconducting element for amplifying the inputted signal, wherein the transconducting element is adapted for forming an amplified signal on the basis of the input signal;
an output stage coupled with the transconducting element to receive the amplified signal;
a negative conductance in the output stage to adjust a gain and a noise figure of the amplifier;and
a feedback element for providing the amplified signal to another input of the transconducting element.

8. The apparatus according to claim 7 further comprising:
a differential output adapted to generate the amplified signal as a differential signal comprising a positive output signal and a negative output signal; and
wherein the feedback element is coupled to the negative output signal to form the feedback signal.

9. The apparatus according to claim 8 further comprising:
a single-ended input coupled to said input of the transconducting element of the amplifier; and
a transformer at the differential output to form the differential output signal.

10. The apparatus according to claim 7, 8 or 9, wherein:
the negative conductance is an adjustable negative resistance.

11. The apparatus according to any of the claims 7 to 10, wherein:
the feedback element comprises a capacitor.

12. The apparatus according to any of the claims 7 to 11, wherein:
the output stage further comprises a tunable LC resonance circuit.

13. The apparatus according to any of the claims 7 to 12, wherein:
the transconducting element is a metal-oxide silicon field effect transistor.

14. The apparatus according to claim 7 or 8, wherein the input is a differential input; further wherein the apparatus comprises:
a first transconducting element and a second transconducting element for amplifying the differential input signal.

15. The apparatus according to any of the claims 7 to 14, wherein the apparatus is a part of a receiver of a wireless communication device.
